# EUROPÄISCHE PATENTSCHRIFT

(11) **EP 3 348 125 B1**
(45) Veröffentlichungstag und Bekanntmachung des Hinweises auf die Patenterteilung: **22.07.2020**
(21) Anmeldenummer: 16751539.4
(22) Anmeldetag: 03.08.2016
(51) Int. Cl.: H05K 13/08, H05K 13/04

(54) **ANLAGE UND VERFAHREN ZUR LÖTSTELLENÜBERPRÜFUNG**
SYSTEM AND METHOD FOR CHECKING SOLDER JOINTS
SYSTÈME ET PROCÉDÉ DE VÉRIFICATION DE POINTS DE BRASAGE

(30) Priorität: 09.09.2015 DE 102015217182
(43) Veröffentlichungstag der Anmeldung: 18.07.2018
(73) Patentinhaber: Robert Bosch GmbH, 70442 Stuttgart (DE)
(72) Erfinder: BRAUN, Marco, 74626 Bitzfeld (DE); GERA, Guenter, 71229 Leonberg (DE)
(86) Internationale Anmeldenummer: PCT/EP2016/068551
(87) Internationale Veröffentlichungsnummer: WO 2017/041965

(56) Entgegenhaltungen:
- EP-A1- 1 619 494
- EP-A2- 1 887 518
- DE-T5-112011 104 723

## Beschreibung

Die Erfindung geht aus von einer Anlage oder einem Verfahren zur Lötstellenüberprüfung nach Gattung der unabhängigen Ansprüche.

Aus dem Stand der Technik bekannte Lötstelleninspektionssysteme werden bei der SMT-Fertigung (SMT = Surface Mount Technology) eingesetzt, um die Qualität der gefertigten Lötstellen zu prüfen.

Bei der SMT-Fertigung werden Lötflächen von Leiterplatten mit Lotpaste bedruckt und die Menge der gedruckten Lotpaste von einer Vorrichtung zur automatischen Lotpastenüberprüfung in einem so genannten SPI-Prozess (SPI = Solder Paste Inspection) geprüft. Anschließend werden die zu lötenden Bauteile auf der bedruckten Leiterplatte platziert und in einem Lötofen wird die Lotpaste aufgeschmolzen, damit durch das entstehende Lot feste elektrisch leitende Verbindungen zwischen den Bauteilen und den korrespondierenden Lötflächen der Leiterplatte entstehen können. Anschließend wird die Qualität der entstandenen Lötstellen durch eine Vorrichtung zur automatischen Lötstelleninspektion in einem so genannten SJI-Prozess (SJI = Solder Joint Inspection) geprüft.

Als automatische Lötstelleninspektionsvorrichtungen werden typischerweise automatische optische Inspektionssysteme (AOI = Automatic Optical Inspection) oder automatische Röntgeninspektionssysteme (AXI = Automatic X-Ray Inspection) eingesetzt. Im Falle einer "Gut"-Klassifikation in der automatischen Lötstelleninspektion geht die Leiterplatte weiter in der Produktionslinie. Die geometrischen Abmessungen der zu lötenden Bauteile können teilweise relativ große Toleranzen aufweisen, was bei der Lötstelleninspektion zu Pseudofehlern oder Schlupf führen kann. Im Falle einer "Schlecht"-Klassifikation in der automatischen Lötstelleninspektion wird daher die korrespondierende Lötstelle der Leiterplatte üblicherweise manuell von einem menschlichen Prüfer in einem Nachüberprüfungsprozess beurteilt, ob tatsächlich eine schlechte Lötstelle vorliegt oder ob die Klassifikation der automatischen Lötstelleninspektion nicht korrekt war und ein so genannter "Pseudofehler" vorliegt. Die manuelle Nachbeurteilung ist üblich, da bei den aus dem Stand der Technik bekannten Anlagen zur Lötstellenüberprüfung ohne manuelle Nachbeurteilung zu hohe Schrottkosten aufgrund von Pseudofehlern im automatischen Lötstelleninspektionsprozess entstehen würden.

Aus der EP 1 619 494 A1 ist eine gattungsgemäße Anlage zur Lötstellenüberprüfung mit einer Vorrichtung zur automatischen Lötstelleninspektion, welche in einem vorgegebenen Inspektionsbereich der Lötfläche mindestens ein Qualitätsmerkmal einer zu überprüfenden Lötstelle erfasst. Die Vorrichtung zur automatischen Lötstelleninspektion bewertet die zu überprüfende Lötstelle in Abhängigkeit des erfassten Qualitätsmerkmals als gute Lötstelle oder als schlechte Lötstelle. Eine Vorrichtung zur automatischen Bauteilüberprüfung ermittelt mit Hilfe eines Verfahrens aus Bilddaten bestimmte Positionen der Bauteile, wobei eine Auswerte- und Steuereinheit in Abhängigkeit der bestimmten Positionen Position und/oder Abmessungen des mindestens einen korrespondierenden Inspektionsbereichs ermittelt und zur Überprüfung der korrespondierenden Lötstelle an die Vorrichtung zur automatischen Lötstelleninspektion vorgibt.

Aus der EP 1 887 518 A2 sind ein Verfahren zum Setzen von Referenzdaten für die automatische Überprüfung von Lötstellen auf einem Substrat und eine Inspektionsvorrichtung zur Durchführung des Verfahrens bekannt. Für jede Art von Komponenten, die auf dem Substrat angebracht werden, wird eine Datenbank vorbereitet, wobei Sätze von Referenzdaten entsprechend den verschiedenen Lötstellenformen in Korrelation mit den Höhen des Lötmittels zur Bildung der Lötstellen mit diesen Formen registriert werden.

Aus der EP 1 619 494 A1 sind Verfahren und Inspektionsvorrichtungen bekannt, welche verwendet werden, um Lötstellen auf einem Substrat zu überprüfen. Hierbei werden Bilder des Substrats sowohl vor und als auch nach der Bauteilbestückung und dem Lötprozess aufgenommen und deren Unterschiede extrahiert.

### Offenbarung der Erfindung

Die Anlage und das Verfahren zur Lötstellenüberprüfung mit den Merkmalen der unabhängigen Patentansprüche 1 bzw. 10 haben den Vorteil, dass die aktuellen geometrischen Abmessungen der zu lötenden Bauteile bei der Vorgabe des Inspektionsbereichs bzw. des Prüffensters berücksichtigt werden können. So kann beispielsweise der Abstand zwischen zwei Inspektionsbereichen, welcher durch eine nominale Bauteillänge bestimmt wird, in Abhängigkeit von der realen Bauteillänge vorgegebene werden. Das bedeutet, dass der Abstand zwischen den Inspektionsbereichen bzw. Prüffenstern bei einem längeren Bauteil vergrößert und bei einem kürzeren Bauteil verkleinert werden kann. So können die Position und/oder Abmessungen des Inspektionsbereichs bzw. des Prüffensters in vorteilhafter Weise an verschiedene Bauteilabmessungen angepasst werden, so dass der Inspektionsbereich bzw. das Prüffenster zur Erfassung des Qualitätsmerkmals optimal ausgeführt und angeordnet sind, um zwischen guten und schlechten Lötstellen unterscheiden zu können.

Ausführungsformen der vorliegenden Erfindung binden die Informationen der automatischen Bauteilüberprüfung direkt in die automatische Lötstelleninspektion ein und ermöglichen damit die direkte, flexible Anpassung des korrespondierenden Auswertealgorithmus bezüglich der gelieferten Informationen über die aktuellen geometrischen Bauteilparameter, wie beispielsweise Länge, Breite, Höhe des Bauteils und/oder des korrespondierenden Kontaktelements und/oder Verbiegungsgrad des Kontaktelements, der mindestens eine geometrische Parameter kann beispielsweise von einer Bestückungsmaschine bestimmt werden.

Ausführungsformen der vorliegenden Erfindung führen eine adaptive Lötstelleninspektion durch, bei welcher die Position und/oder Abmessungen des Inspektionsbereichs bzw. des Prüffensters, welche die Vorrichtung zur automatischen Lötstelleninspektion verwendet, an die jeweiligen zu lötenden Bauteile angepasst werden kann. Dadurch können Schlupf und Pseudofehler gegenüber einer standardmäßigen Lötstelleninspektion in vorteilhafter Weise massiv verringert werden. Somit können Ausführungsformen der vorliegenden Erfindung die Überprüfung der Lötstellen von SMT-Bauformen ermöglichen, welche bisher aufgrund mangelnder Trennbarkeit von guten und schlechten Teilen über übliche Bauteiltoleranzen hinweg nicht überprüft werden können. Des Weiteren wäre es denkbar, dass sich dadurch die Pseudofehlerrate soweit reduzieren lässt, dass auf eine manuelle Nachüberprüfung verzichtet werden kann. In Abhängigkeit des gewählten mindestens einen Qualitätsmerkmals kann die Vorrichtung zur automatischen Lötstelleninspektion beispielsweise die zu überprüfende Lötstelle als gute Lötstelle bewerten, wenn das mindestens eine Qualitätsmerkmal gleich dem vorgegebenen Schwellwert ist oder über dem vorgegebenen Schwellwert liegt, oder als schlechte Lötstelle bewerten, wenn das mindestens eine Qualitätsmerkmal unter dem vorgegebenen Schwellwert liegt. Alternativ kann die Vorrichtung zur automatischen Lötstelleninspektion die zu überprüfende Lötstelle in Abhängigkeit des gewählten mindestens einen Qualitätsmerkmals beispielsweise als gute Lötstelle bewerten, wenn das mindestens eine Qualitätsmerkmal unter dem vorgegebenen Schwellwert liegt, oder als schlechte Lötstelle bewerten, wenn das mindestens eine Qualitätsmerkmal gleich dem vorgegebenen Schwellwert ist oder über dem vorgegebenen Schwellwert liegt.

Ausführungsformen der vorliegenden Erfindung stellen eine Anlage zur Lötstellenüberprüfung mit einer Vorrichtung zur automatischen Lötstelleninspektion zur Verfügung, welche in einem vorgegebenen Inspektionsbereich der Lötfläche mindestens ein Qualitätsmerkmal einer zu überprüfenden Lötstelle erfasst und die zu überprüfende Lötstelle in Abhängigkeit des erfassten mindestens einen Qualitätsmerkmals als gute Lötstelle oder als schlechte Lötstelle bewertet. Hierbei bestimmt eine Vorrichtung zur automatischen Bauteilüberprüfung mindestens einen geometrischen Parameter eines zu lötenden Bauteils. Eine Auswerte- und Steuereinheit ermittelt in Abhängigkeit des bestimmten mindestens einen geometrischen Parameters des zu lötenden Bauteils Position und/oder Abmessungen des mindestens einen korrespondierenden Inspektionsbereichs und gibt diese zur Überprüfung der korrespondierenden Lötstelle an die Vorrichtung zur automatischen Lötstelleninspektion vor.

Zudem wird ein Verfahren zur Lötstellenüberprüfung mit einer automatischen Lötstelleninspektion vorgeschlagen, durch welche in einem vorgegebenen Inspektionsbereich der Lötfläche mindestens ein Qualitätsmerkmal einer zu überprüfenden Lötstelle erfasst wird, wobei die zu überprüfende Lötstelle in Abhängigkeit des erfassten mindestens einen Qualitätsmerkmals als gute Lötstelle oder als schlechte Lötstelle bewertet wird. Hierbei ermittelt eine automatische Bauteilüberprüfung mindestens einen geometrischen Parameter eines zu lötenden Bauteils, wobei Position und/oder Abmessungen des mindestens einen korrespondierenden Inspektionsbereichs für die Lötstelleninspektion in Abhängigkeit des bestimmten mindestens einen geometrischen Parameters vorgegeben werden.

Die erfindungsgemäße Anlage und das erfindungsgemäße Verfahren können beispielsweise in einer Anlage zur Bestückung einer Leiterplatte zur Lötstellenüberprüfung eingesetzt werden.

Ausführungsformen der Erfindung können beispielsweise in Software oder Hardware oder in einer Mischform aus Software und Hardware beispielsweise in der Auswerte- und Steuereinheit implementiert werden.

Unter der Auswerte- und Steuereinheit kann vorliegend ein elektrisches Gerät, wie beispielsweise ein Steuergerät verstanden werden, welches erfasste Sensorsignale verarbeitet bzw. auswertet. Die Auswerte- und Steuereinheit kann mindestens eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Auswerte- und Steuereinheit beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind. Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung der Auswertung verwendet wird, wenn das Programm von der Auswerte- und Steuereinheit ausgeführt wird.

Bei Ausführungsformen der vorliegenden Erfindung kann die Auswerte- und Steuereinheit beispielsweise als Teil der Vorrichtung zur automatischen Bauteilüberprüfung oder als Teil der Vorrichtung zur automatischen Lötstelleninspektion oder als eigenständige Baugruppe ausgeführt werden. Die Vorrichtung zur automatischen Lötstelleninspektion kann beispielsweise als optisches System oder als Röntgensystem ausgeführt werden.

Die Vorrichtung zur automatischen Lötstelleninspektion kann als das mindestens eine Qualitätsmerkmal eine Breite und/oder Höhe und/oder Länge der Lötstelle und/oder innerhalb des Inspektionsbereichs eine Anzahl von Pixeln mit einer vorgegebenen Eigenschaft und/oder Abschnitte mit einer vorgegebenen Eigenschaft. bestimmen. Der Inspektionsbereich bzw. das Prüffenster repräsentiert den Lötstellenbereich, in welchem typischerweise die Ausbildung eines Lötmeniskus als Qualitätsmerkmal für eine gute Lötstelle geprüft werden kann. Bei einer optischen Überprüfung zur Unterscheidung zwischen guter und schlechter Lötstelle kann als die vorgegebene Eigenschaft beispielsweise Helligkeit und/oder Farbe und/oder Größe der im Inspektionsbereich erkannten Pixel ermittelt und ausgewertet werden. So enthält eine "gute" Lötstelle beispielsweise deutlich mehr erkennbare Pixel als eine "schlechte" Lötstelle. Des Weiteren können beispielsweise innerhalb des Inspektionsbereichs Grauwert-Gradienten und/oder mittlere Grauwerte zumindest für Abschnitte des Inspektionsbereichs oder für den gesamten Inspektionsbereich ermittelt werden. Durch eine dreidimensionale Erfassung der zu überprüfenden Lötstelle können insbesondere Informationen über die Höhe bzw. den Höhenverlauf des Lötminiskus als Qualitätsmerkmal für die zu überprüfende Lötstelle ausgewertet werden.

Durch die in den abhängigen Ansprüchen aufgeführten Maßnahmen und Weiterbildungen sind vorteilhafte Verbesserungen der im unabhängigen Patentanspruch 1 angegebenen Anlage zur Lötstellenüberprüfung und des im unabhängigen Patentanspruch 10 angegebenen Verfahrens zur Lötstellenüberprüfung möglich.

In vorteilhafter Ausgestaltung der Erfindung kann die Vorrichtung zur automatischen Lötstelleninspektion das in einem vorgegebenen Inspektionsbereich der zu überprüfenden Lötstelle erfasste mindestens eine Qualitätsmerkmal mit mindestens einem vorgegebenen Schwellwert vergleichen und in Abhängigkeit des Vergleichsergebnisses die zu überprüfende Lötstelle als gute Lötstelle oder als schlechte Lötstelle bewerten.

In weiterer vorteilhafter Ausgestaltung der Erfindung können eine Vorrichtung zur automatischen Lötflächenüberprüfung, welche mindestens einen geometrischen Parameter der mit Lot benetzbaren Lötfläche der zu überprüfenden Lötstelle bestimmen kann und/oder eine Vorrichtung zur automatischen Lotpastenüberprüfung vorgesehen werden, welche eine auf der Lötfläche der zu überprüfenden Lötstelle aufgebrachte Lotpastenmenge bestimmen kann.

In weiterer vorteilhafter Ausgestaltung der Erfindung kann die Auswerte- und Steuereinheit Informationen über den bestimmten mindestens einen geometrischen Parameter der mit Lot benetzbaren Lötfläche und/oder die bestimmte auf die Lötfläche aufgebrachte Lotpastenmenge bei der Ermittlung der Position und/oder der Abmessungen des mindestens einen korrespondierenden Inspektionsbereichs verwenden. Zudem kann die Auswerte- und Steuereinheit den mindestens einen geometrischen Parameter eines zu lötenden Bauteils und/oder den für die Lötfläche bestimmten mindestens einen geometrischen Parameter und/oder die für die zu überprüfende Lötstelle bestimmte Lotpastenmenge bei der Ermittlung des Schwellwerts für das mindestens eine Qualitätsmerkmal verwenden. Dadurch können Ausführungsformen der vorliegenden Erfindung zusätzlich die Informationen der automatischen Lötflächenüberprüfung und/oder der automatischen Lotpastenüberprüfung direkt in die automatische Lötstelleninspektion einbinden und damit die direkte, flexible Anpassung des korrespondierenden Auswertealgorithmus bezüglich der gelieferten Informationen über den aktuellen mindestens einen Parameter und/oder die aktuelle Lotpastenmenge ermöglichen. Dadurch können Schlupf und Pseudofehler gegenüber einer standardmäßigen Lötstelleninspektion in vorteilhafter Weise weiter verringert werden. In weiterer vorteilhafter Ausgestaltung der Erfindung kann die Vorrichtung zur automatischen Bauteilüberprüfung als geometrischer Parameter des zu lötenden Bauteils beispielsweise eine aktuelle Bauteillänge ermitteln. Die Vorrichtung zur automatischen Bauteilüberprüfung kann dann den Abstand zwischen zwei Inspektionsbereichen in Abhängigkeit der aktuellen Bauteillänge vorgeben.

In weiterer vorteilhafter Ausgestaltung der Erfindung kann ein Nachüberprüfungsplatz vorhanden sein, an welchem ein menschlicher Prüfer die als schlechte Lötstelle bewerteten Lötstellen nochmals überprüft.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt ein schematisches Blockdiagramm eines ersten Ausführungsbeispiels einer erfindungsgemäßen Anlage zur Lötstellenüberprüfung.
Fig. 2 zeigt ein schematisches Flussdiagramm eines ersten Ausführungsbeispiels eines Verfahrens zur Bestückung einer Leiterplatte, in welches ein Ausführungsbeispiel eines erfindungsgemäßen Verfahrens zur Lötstellenüberprüfung eingebunden ist.
Fig. 3 zeigt eine schematische Darstellung von mehreren eingelöteten Bauteilen mit korrespondierenden zu überprüfenden Lötstellen.
Fig. 4 zeigt eine schematische Darstellung der zu überprüfenden Lötstellen aus Fig. 3, die von einer herkömmlichen Anlage zur Lötstellenüberprüfung erzeugt wurde.
Fig. 5 zeigt eine schematische Darstellung der zu überprüfenden Lötstellen aus Fig. 3, die von einer erfindungsgemäßen Anlage zur Lötstellenüberprüfung erzeugt wurde.
Fig. 6 zeigt ein schematisches Blockdiagramm eines zweiten Ausführungsbeispiels einer erfindungsgemäßen Anlage zur Lötstellenüberprüfung.
Fig. 7 zeigt ein schematisches Flussdiagramm eines zweiten Ausführungsbeispiels eines Verfahrens zur Bestückung einer Leiterplatte, in welches ein Ausführungsbeispiel eines erfindungsgemäßen Verfahrens zur Lötstellenüberprüfung eingebunden ist.

### Ausführungsformen der Erfindung

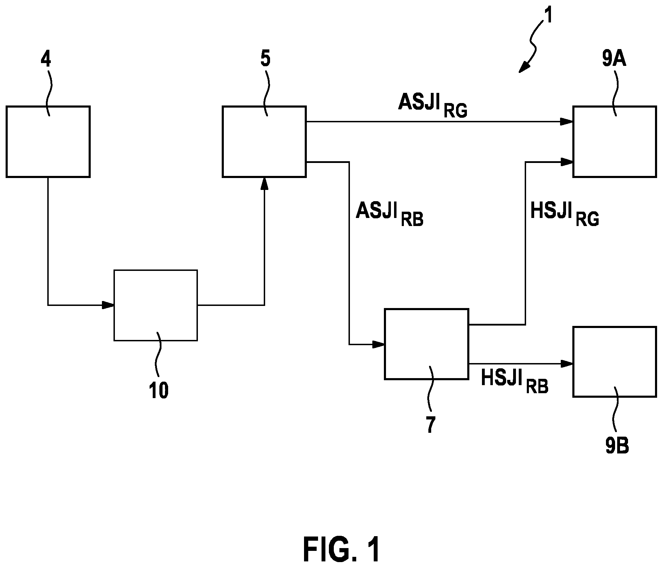

Wie aus Fig. 1 bis 7 ersichtlich ist, umfassen die dargestellten Ausführungsbeispiele einer erfindungsgemäßen Anlage 1, 1A zur Lötstellenüberprüfung jeweils eine Vorrichtung 5 zur automatischen Lötstelleninspektion, welche in einem vorgegebenen Inspektionsbereich 12.1, 12.2 der Lötfläche 14 mindestens ein Qualitätsmerkmal einer zu überprüfenden Lötstelle 11 erfasst und die zu überprüfende Lötstelle 11 in Abhängigkeit des erfassten mindestens einen Qualitätsmerkmals als gute Lötstelle ASJIR_{G} oder als schlechte Lötstelle ASJIR_{B} bewertet. Hierbei bestimmt eine Vorrichtung 4 zur automatischen Bauteilüberprüfung mindestens einen geometrischen Parameter eines zu lötenden Bauteils 16, 16A, 16B, und eine Auswerte- und Steuereinheit 10 ermittelt in Abhängigkeit des bestimmten mindestens einen geometrischen Parameters des zu lötenden Bauteils 16, 16A, 16B Position und/oder Abmessungen des mindestens einen korrespondierenden Inspektionsbereichs 12.1, 12.2 und gibt diese zur Überprüfung der korrespondierenden Lötstelle 11 an die Vorrichtung 5 zur automatischen Lötstelleninspektion vor.

Im dargestellten Ausführungsbeispiel ist die Vorrichtung 5 zur automatischen Lötstelleninspektion als optisches System ausgeführt, welche eine Anzahl von im Inspektionsbereich 12 erkannten Pixeln bzw. eine daraus bestimmte aktuelle Breite der überprüften Lötstelle 11 als das mindestens eine Qualitätsmerkmal zur Bewertung der korrespondierenden Lötstelle bestimmt. Alternativ kann die Vorrichtung 5 zur automatischen Lötstelleninspektion als Röntgensystem ausgeführt werden. Zusätzlich oder alternativ können auch andere vorgegebene Eigenschaften, wie beispielsweise Farbe und/oder Größe und/oder Intensität der im Inspektionsbereich 12.1, 12.2 erkannten Pixel zur Unterscheidung zwischen einer guten Lötstelle und einer schlechten Lötstelle erfasst und ausgewertet werden. Zudem können beispielsweise innerhalb des Inspektionsbereichs 12.1, 12.2 Grauwert-Gradienten und/oder mittlere Grauwerte zumindest für Abschnitte des Inspektionsbereichs 12.1, 12.2 oder für den gesamten Inspektionsbereich 12.1, 12.2 als Qualitätsmerkmale ermittelt und zur Unterscheidung zwischen einer guten Lötstelle und einer schlechten Lötstelle ausgewertet werden. Des Weiteren können zusätzlich oder alternativ zur Breite der Lötstelle 11 auch Höhe und/oder Länge der zu überprüfenden Lötstelle 11 zur Unterscheidung zwischen einer guten Lötstelle und einer schlechten Lötstelle erfasst und ausgewertet werden.

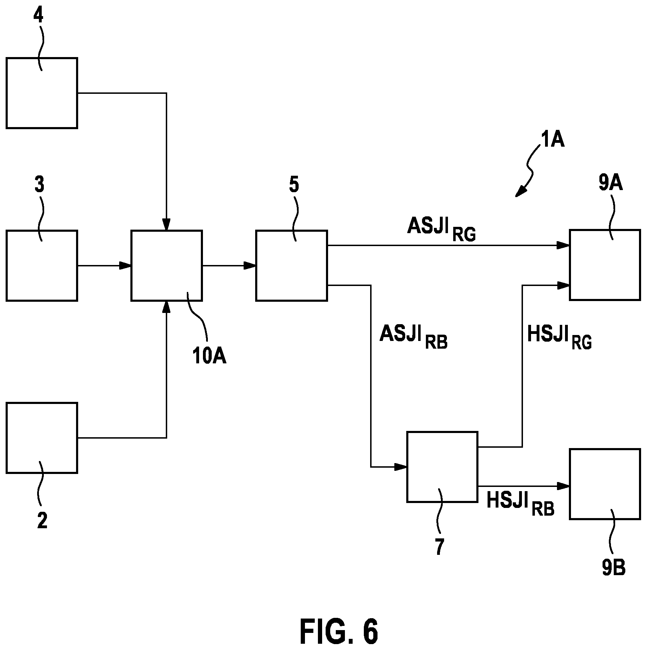

Wie aus Fig. 1 und 6 weiter ersichtlich ist, umfasst die Anlage 1, 1A zur Lötstellenüberprüfung in den dargestellten Ausführungsbeispielen jeweils einen Nachüberprüfungsplatz 7, an welchem ein menschlicher Prüfer die als schlechte Lötstelle ASJIR_{B} bewerteten Lötstellen nochmals überprüft. Zudem ist die Anlage 1, 1A zur Lötstellenüberprüfung in eine Anlage zur Bestückung von Leiterplatten 18 eingebunden. Hierbei werden Leiterplatten 18 mit von der Vorrichtung 5 zur automatischen Lötstelleninspektion als gut bewerteten Lötstellen ASJI_{RG} direkt einem nachfolgenden Produktionsprozess 9A übergeben. Leiterplatten 18 mit mindestens einer von der Vorrichtung 5 zur automatischen Lötstelleninspektion als schlecht bewerteten Lötstelle ASJI_{RB}, werden an den Nachüberprüfungsplatz 7 übergeben. Wird die von der Vorrichtung 5 zur automatischen Lötstelleninspektion als schlecht bewertete mindestens eine Lötstelle ASJI_{RB} vom Prüfer in einer Nachprüfung als gute Lötstelle HSJI_{RG} bewertet, dann wird die Leiterplatte 18 ebenfalls an den nachfolgenden Produktionsprozess 9A übergeben. Wird die von der Vorrichtung 5 zur automatischen Lötstelleninspektion als schlecht bewertete mindestens eine Lötstelle ASJI_{RB} vom Prüfer in der Nachprüfung ebenfalls als schlechte Lötstelle HSJI_{RB} bewertet, dann wird die Leiterplatte 18 an einen Nachbearbeitungsprozess bzw. einen Ausschussprozess 9B übergeben.

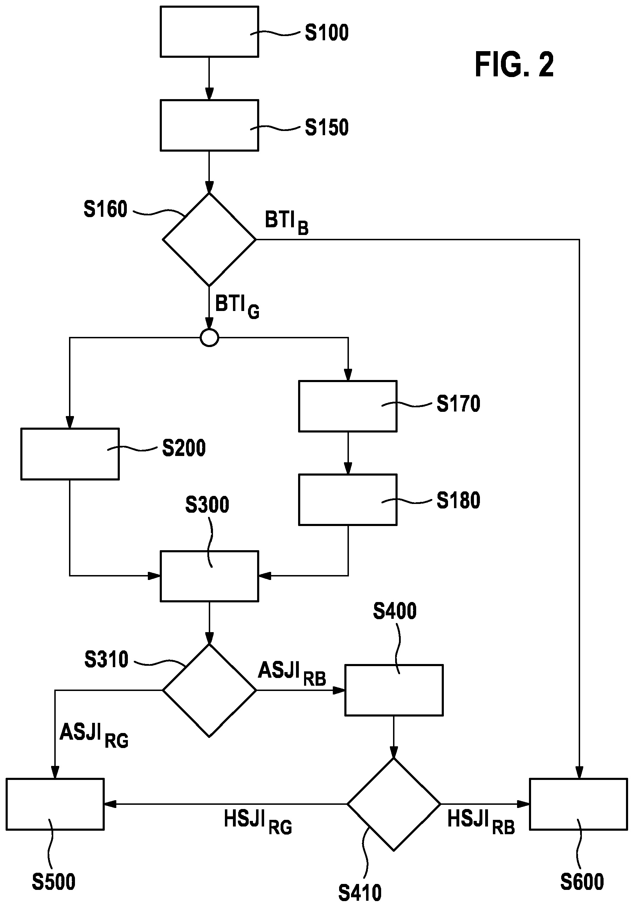

Wie aus Fig. 2 weiter ersichtlich ist, werden bei dem dargestellten ersten Ausführungsbeispiel eines Verfahrens zur Bestückung einer Leiterplatte 18, in welches das erfindungsgemäße Verfahren zur Lötstellenüberprüfung eingebettet ist, in einem Schritt S100 die Lötflächen 14 der Leiterplatte mit Lotpaste bedruckt. Im Schritt S150 wird eine automatische Bauteilüberprüfung durchgeführt, durch welche mindestens ein geometrischer Parameter des jeweiligen Bauteils 16, 16A, 16B, wie beispielsweise Abmessungen des Bauteils 16, 16A, 16B und/oder der Kontaktelemente 16.1 und/oder Verbiegungsgrad der Kontaktelemente 16.1 usw., und/oder Beschädigungen des Bauteils 16, 16A, 16B erfasst und bestimmt werden. Im Schritt S160 wird überprüft, ob das Bauteil 16, 16A, 16B den vorgegebenen Anforderungen entspricht. Wird im Schritt S160 festgestellt, dass das Bauteil 16, 16A, 16B den vorgegebenen Anforderungen nicht entspricht, dann wird das Bauteil 16, 16A, 16B als schlechtes Bauteil BTI_{B} an einen Nachbearbeitungsprozess bzw. Ausschussprozess übergeben, welcher im Schritt S600 durchgeführt wird. Wird das Bauteil 16, 16A, 16B im Schritt S160 als gutes Bauteil BTI_{G} bewertet, dann wird im Schritt S200 in Abhängigkeit des mindestens einen bestimmten geometrischen Parameters des jeweiligen Bauteils 16, 16A, 16B eine Position und/oder Abmessungen des mindestens einen korrespondierenden Inspektionsbereichs 12.1, 12.2 ermittelt und zur Lötstelleninspektion des Bauteils16, 16A, 16B für das weitere Verfahren vorgegeben. Im Schritt S170 werden die zu lötenden als gut bewerteten Bauteile BTI_{G} auf der bedruckten Leiterplatte 18 platziert. Die Schritte S150, S160 und S170 können beispielsweise von einem Bestückungsautomaten durchgeführt werden, welcher die Vorrichtung 4 zur Bauteilüberprüfung umfasst.

Im Schritt S180 wird die Leiterplatte 18 mit den platzierten Bauteilen 16, 16A, 16B einem Lötofen zugeführt, in welchem die Lotpaste aufgeschmolzen wird, damit durch das entstehende Lot 15 eine feste Verbindung zwischen den Bauteilen 16, 16A, 16B und den Lötflächen 14 der Leiterplatte 18 entsteht. Die Schritte S170 und S180 werden parallel zum Schritt S200 ausgeführt, in welchem neben der Position und/oder den Abmessungen des mindestens einen korrespondierenden Inspektionsbereichs 12.1, 12.2 auch der Schwellwert für das mindestens eine Qualitätsmerkmal zur automatischen Lötstelleninspektion ermittelt und vorgegeben wird. Der Schwellwert für das mindestens eine Qualitätsmerkmal zur automatischen Lötstelleninspektion kann im Schritt S200 beispielsweise in Abhängigkeit des mindestens einen geometrischen Parameters eines zu lötenden Bauteils ermittelt werden.

Im Schritt S300 wird die automatische Lötstelleninspektion durchgeführt, durch welche in dem im Schritt S200 vorgegebenen Inspektionsbereich 12.1, 12.2 der Lötfläche 14 das mindestens eine Qualitätsmerkmal der zu überprüfenden Lötstelle 11 erfasst wird. Im Schritt S310 wird der Wert des mindestens einen Qualitätsmerkmals mit dem vorgegebenen Schwellwert verglichen. Die zu überprüfende Lötstelle 11 wird im dargestellten Ausführungsbeispiel im Schritt S310 als gute Lötstelle ASJIR_{G} bewertet, wenn das mindestens eine Qualitätsmerkmal gleich dem vorgegebenen Schwellwert ist oder über dem vorgegebenen Schwellwert liegt. Die zu überprüfende Lötstelle wird als schlechte Lötstelle ASJIR_{B} bewertet, wenn das mindestens eine Qualitätsmerkmal unter dem vorgegebenen Schwellwert liegt. In Abhängigkeit des gewählten mindestens einen Qualitätsmerkmals kann die zu überprüfende Lötstelle alternativ beispielsweise als gute Lötstelle bewertet werden, wenn das mindestens eine Qualitätsmerkmal unter dem vorgegebenen Schwellwert liegt, oder als schlechte Lötstelle bewertet werden, wenn das mindestens eine Qualitätsmerkmal gleich dem vorgegebenen Schwellwert ist oder über dem vorgegebenen Schwellwert liegt.

Sind die Lötstellen im Schritt S310 als gute Lötstellen ASJI_{RG} bewertet, dann wird die korrespondierende Leiterplatte 18 direkt dem nachfolgenden Produktionsprozess 9A übergeben, welcher im Schritt S500 durchgeführt wird. Ist mindestens eine Lötstelle 11 der Leiterplatte 18 als schlechte Lötstelle ASJI_{RB} bewertet worden, dann wird die Leiterplatte 18 im Schritt S400 an den Nachüberprüfungsplatz 7 übergeben. Wird die bei der automatischen Lötstelleninspektion als schlecht bewertete mindestens eine Lötstelle ASJI_{RB} im Schritt S410 vom Prüfer in der Nachprüfung als gute Lötstelle HSJI_{RG} bewertet, dann wird die Leiterplatte 18 ebenfalls an den nachfolgenden Produktionsprozess 9A übergeben, welcher im Schritt S500 durchgeführt wird. Wird die bei der automatischen Lötstelleninspektion als schlecht bewertete mindestens eine Lötstelle ASJI_{RB} im Schritt S410 vom Prüfer in der Nachprüfung ebenfalls als schlechte Lötstelle HSJI_{RB} bewertet, dann wird die Leiterplatte an den Nachbearbeitungsprozess bzw. Ausschussprozess 9B übergeben, welcher im Schritt S600 durchgeführt wird.

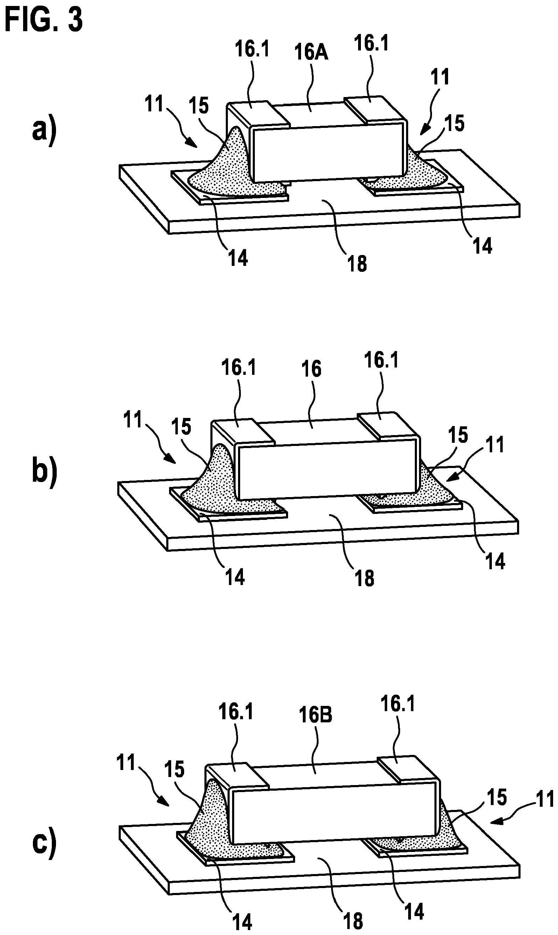

Wie aus Fig. 3 bis 5 ersichtlich ist, sind in den dargestellten Ausschnitten einer Leiterplatte 18 jeweils ein elektronisches Bauteil 16, 16A, 16 mit zwei zu überprüfende Lötstellen 11 dargestellt. Die Lötstellen 11 sind jeweils zwischen einem Kontaktelement 16.1 des jeweiligen elektronischen Bauteils 16, 16A, 16B und einer korrespondierenden Lötfläche 14 der Leiterplatte 18 ausgebildet, wobei das Lot 15 der Lötstelle 11 durch Aufschmelzen der auf die Lötfläche 14 aufgebrachten Lotpaste im Lötofen erzeugt wird. Hierbei repräsentieren die in den Bereichen b) der Fig. 3 bis 5 dargestellten Bauelemente 16 jeweils ein Bauteil 16 mit einer nominalen Bauteillänge. Die in den Bereichen a) der Fig. 3 bis 5 dargestellten Bauelemente 16A repräsentieren jeweils ein Bauteil 16A mit einer kürzen als die nominale Bauteillänge. Die in den Bereichen c) der Fig. 3 bis 5 dargestellten Bauelemente 16B repräsentieren jeweils ein Bauteil 16B mit einer längeren als die nominale Bauteillänge.

In aus dem Stand der Technik bekannten Prüfalgorithmen wird eine Abfolge von Prüfschritten mit den dafür erforderlichen Parametern und den für die Trennung von guten und schlechten Lötstellen 11 verwendeten fest vorgegebenen Inspektionsbereichen 12.1, 12.2 für die Lötstelleninspektion in der Regel an ausgewählten Bauteilgeometrien festgelegt. In nachfolgenden Prüfaufgaben an den zu überprüfenden Lötstellen 11 in unterschiedlichen Produkten können Variationen in den Bauteilgeometrien auftreten, die bei der einmaligen Erstellung und Vorgabe der Inspektionsbereiche 12.1, 12.2 für die Lötstelleninspektion nicht umfassend berücksichtigt werden können und demzufolge zu erhöhtem Schlupf und/oder zu höheren Pseudofehlerraten führen können. Variationen in den Bauteilgeometrien sind beispielsweise durch Fertigungstoleranzen bedingt.

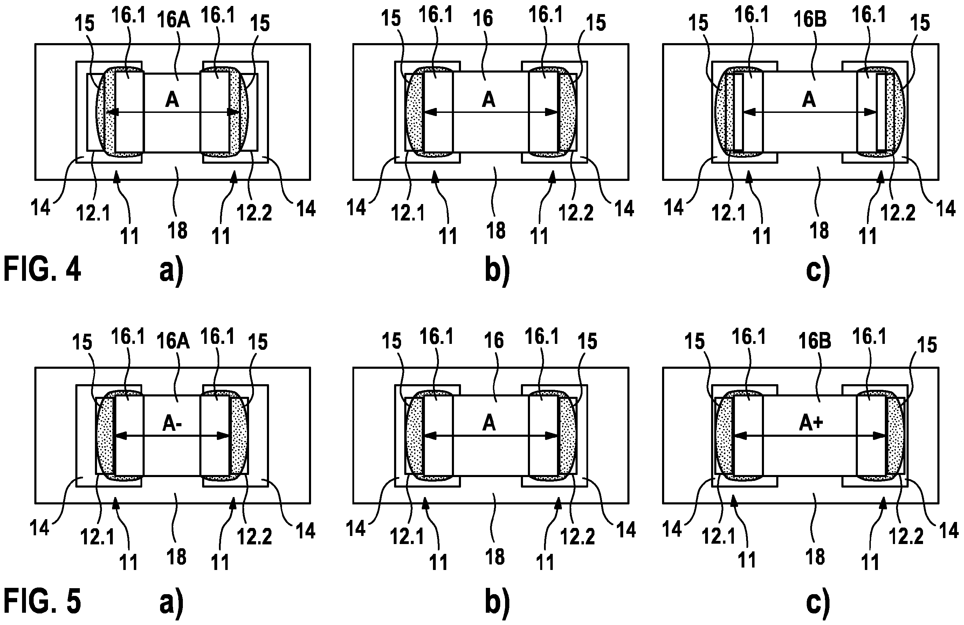

Wie aus Fig. 4 weiter ersichtlich ist, verwendet die herkömmlichen Prüfalgorithmen unabhängig von den aktuellen geometrischen Parametern des zu lötenden Bauteils 16, 16A, 16B einen fest vorgegebenen Abstand A zwischen den beiden Inspektionsbereichen 12.1, 12.2, welche zur Überprüfung der beiden Lötstellen 11 des Bauteils 16, 16A, 16B eingesetzt werden. Der fest vorgegebene Abstand A wird bezogen auf das Bauteil 16 mit der nominalen Bauteillänge vorgegeben. Daher liegen die beiden zu überprüfenden Lötstellen 11 des nominalen Bauteils 16 genau innerhalb des jeweiligen Inspektionsbereichs 12.1, 12.2 und können überprüft werden. Bei dem kürzeren Bauteil 16A liegen die beiden zu überprüfenden Lötstellen 11 zumindest teilweise außerhalb des jeweiligen Inspektionsbereichs 12.1, 12.2, so dass die zu überprüfenden Lötstellen 11 als schlechte Lötstellen bewertet werden. Auch bei dem längeren Bauteil 16B liegen die beiden zu überprüfenden Lötstellen 11 zumindest teilweise außerhalb des jeweiligen Inspektionsbereichs 12.1, 12.2, so dass die zu überprüfenden Lötstellen 11 ebenfalls als schlechte Lötstellen bewertet werden.

Wie aus Fig. 5 weiter ersichtlich ist, verwendet die erfindungsgemäß Anlage 1, 1A zur Lötstellenüberprüfung bzw. das erfindungsgemäße Verfahren zur Lötstellenüberprüfung von den aktuellen geometrischen Parametern des zu lötenden Bauteils 16, 16A, 16B abhängige Abstände A, A-, A+ zwischen den beiden Inspektionsbereichen 12.1, 12.2, welche zur Überprüfung der beiden Lötstellen 11 des Bauteils 16, 16A, 16B eingesetzt werden. Der jeweilige Abstand A, A-, A+ wird in den dargestellten Ausführungsbeispielen auf die aktuelle Bauteillänge des zu lötenden Bauteils 16, 16A, 16B bezogen. Daher liegen die beiden zu überprüfenden Lötstellen 11 unabhängig von der aktuellen Bauteillänge des zu lötenden Bauteils 16, 16A, 16B genau innerhalb des jeweiligen Inspektionsbereichs 12.1, 12.2 und können überprüft werden. Wie aus Fig. 5 weiter ersichtlich ist, wird bei dem Bauteil 16 mit nominaler Bauteillänge der Abstand A verwendet. Bei dem kürzeren Bauteil 16A wird ein kürzerer Abstand A- und bei dem längeren Bauteil 16B ein längerer Abstand A+ verwendet.

Wie aus Fig. 6 weiter ersichtlich ist, umfasst das dargestellte zweite Ausführungsbeispiele einer erfindungsgemäßen Anlage 1A zur Lötstellenüberprüfung im Unterschied zu dem in Fig. 1 dargestellten ersten Ausführungsbeispiel einer erfindungsgemäßen Anlage 1 zur Lötstellenüberprüfung neben der Vorrichtung 4 zur automatischen Bauteilüberprüfung, welche mindestens einen geometrischen Parameter eines zu lötenden Bauteils 16, 16A, 16B ermittelt, eine Vorrichtung 2 zur automatischen Lötflächenüberprüfung, welche mindestens einen geometrischen Parameter einer mit Lot 15 benetzbaren Lötfläche 14 der zu überprüfenden Lötstelle 11 ermittelt, und eine Vorrichtung 3 zur automatischen Lotpastenüberprüfung, welche eine auf der Lötfläche 14 der zu überprüfenden Lötstelle 11 aufgebrachte Lotpastenmenge bestimmt. Im zweiten Ausführungsbeispiel verwendet die Auswerte- und Steuereinheit 10A den bestimmten mindestens einen geometrischen Parameter eines zu lötenden Bauteils 16, 16A, 16B und/oder den für die zu überprüfende Lötstelle 11 ermittelten mindestens einen geometrischen Parameter der mit Lot 15 benetzbaren Lötfläche 14 und/oder die für die zu überprüfende Lötstelle 11 bestimmte Lotpastenmenge bei der Ermittlung des Schwellwerts für das mindestens eine Qualitätsmerkmal. Zudem gibt die Auswerte- und Steuereinheit 10A Position und/oder Abmessungen des mindestens einen korrespondierenden Inspektionsbereichs 12.1, 12.2 für die Lötstelleninspektion in Abhängigkeit des bestimmten mindestens einen geometrischen Parameters des zu lötenden Bauteils 16, 16A, 16B und/oder des ermittelten mindestens einen geometrischen Parameters der mit Lot 15 benetzbaren Lötfläche 14 und/oder der bestimmten auf die Lötfläche 14 aufgebrachten Lotpastenmenge vor. Analog zum ersten Ausführungsbeispiel erfasst die Vorrichtung 5 zur automatischen Lötstelleninspektion in einem vorgegebenen Inspektionsbereich 12.1, 12.2 der Lötfläche 14 das mindestens eine Qualitätsmerkmal der zu überprüfenden Lötstelle 11 und vergleicht das mindestens eine Qualitätsmerkmal mit einem vorgegebenen Schwellwert. Hierbei bewertet die Vorrichtung 5 zur automatischen Lötstelleninspektion die zu überprüfende Lötstelle in Abhängigkeit des Vergleichsergebnisses als gute Lötstelle ASJIR_{G} oder als schlechte Lötstelle ASJIR_{B}.

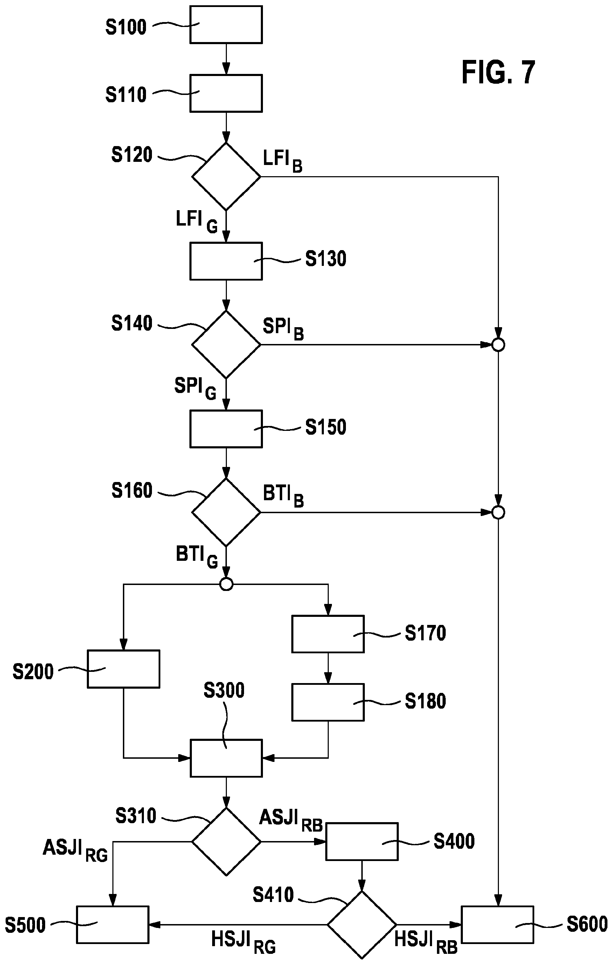

Wie aus Fig. 7 weiter ersichtlich ist, werden bei dem dargestellten zweiten Ausführungsbeispiel eines Verfahrens zur Bestückung einer Leiterplatte 18, in welches das erfindungsgemäße Verfahren zur Lötstellenüberprüfung eingebettet ist, in einem Schritt S100 die Lötflächen 14 der Leiterplatte 18 mit Lotpaste bedruckt.

Im Schritt S110 wird eine automatische Überprüfung der mit Lot 15 benetzbaren Lötfläche 14 der Leiterplatte 18 durchgeführt, durch welche mindestens ein aktueller geometrischer Parameter der mit Lot 15 benetzbaren Lötfläche 14, wie beispielsweise Breite und/oder Länge der mit Lot 15 benetzbaren Lötfläche 14 usw., erfasst und bestimmt werden. Die Größe der mit Lot 15 benetzbaren Lötfläche 14 ist von den Abmessungen der elektrisch leitenden Kontaktfläche und/oder vom aufgebrachten Lötstopplack abhängig. So kann der aufgebrachte Lötstopplack die mit Lot 15 benetzbare Lötfläche 14 der elektrisch leitenden Kontaktfläche verkleinern, wenn sich Lötstopplack auf der elektrisch leitenden Kontaktfläche befindet. Der mindestens eine geometrische Parameter der mit Lot 15 benetzbaren Lötfläche 14 kann alternativ auch vor dem Bedrucken der Leiterplatte 18 mit Lotpaste im Schritt S100 ermittelt werden. Im Schritt S120 wird überprüft, ob der mindestens eine bestimmte geometrische Parameter der mit Lot 15 benetzbaren Lötfläche 14 innerhalb eines vorgegebenen Bereichs liegen. Im dargestellten Ausführungsbeispiel ist für die zu überprüfende Lötstelle 11 eine optimale Breite der mit Lot 15 benetzbaren Lötfläche 14 als 100% vorgegeben. Bei der automatischen Lötflächenüberprüfung wird die überprüfte Lotfläche 14 im Schritt S120 als gute Lötfläche LFI_{G} bewertet, wenn beispielsweise die Breite der mit Lot 15 benetzbaren Lötfläche 14 in einem vorgegebenen Bereich von 50% bis 150% liegt. Die überprüfte Lötfläche 14 wird im Schritt S120 als schlechte Lötfläche LFI_{B} bewertet, wenn die Breite der mit Lot 15 benetzbaren Lötfläche 14 außerhalb des vorgegebenen Bereichs liegt. In diesem Fall wird die korrespondierende Leiterplatte 18 dem Nachbearbeitungsprozess bzw. Ausschussprozess übergeben, welcher im Schritt S600 durchgeführt wird. Selbstverständlich können auch andere Bereiche zur Bewertung der mit Lot 15 benetzbaren Lötfläche 14 vorgegeben werden.

Sind die mit Lot 15 benetzbaren Lötflächen 14 der Leiterplatte 18 im Schritt S120 als gute Lötflächen LFI_{G} bewertet worden, dann wird im Schritt S130 eine automatische Lotpastenüberprüfung durchgeführt, durch welche die auf eine Lötfläche 14 aufgebrachte Lotpastenmenge bestimmt wird. In Schritt S140 wird überprüft, ob die bestimmte Lotpastenmenge innerhalb eines vorgegebenen Bereichs liegt. Im dargestellten Ausführungsbeispiel ist für die zu überprüfende Lötstelle 11 eine optimale Lotpastenmenge als 100% vorgegeben. Bei der automatischen Lotpastenüberprüfung wird die bestimmte Lotpastenmenge im Schritt S140 als gute Lotpastenmenge SPI_{G} bewertet, wenn sie beispielsweise im vorgegebenen Bereich von 50 bis 150% liegt. Die bestimme Lotpastenmenge wird im Schritt S160 als schlechte Lotpastenmenge SPI_{B} bewertet, wenn sie außerhalb des vorgegebenen Bereichs liegt. In diesem Fall wird die korrespondierende Leiterplatte 18 dem Nachbearbeitungsprozess bzw. Ausschussprozess übergeben, welcher im Schritt S600 durchgeführt wird. Selbstverständlich können auch andere Bereiche zur Bewertung der Lotpastenmenge vorgegeben werden. Alternativ kann die Lotpastenüberprüfung auch vor der Lötflächenüberprüfung durchgeführt werden.

Im Schritt S150 wird eine automatische Bauteilüberprüfung durchgeführt, durch welche die geometrische Parameter des jeweiligen Bauteils 16, 16A, 16B, wie beispielsweise Abmessungen des Bauteils 16 und/oder der Kontaktelemente 16.1 und/oder Verbiegungsgrad der Kontaktelemente 16.1 usw., und/oder Beschädigungen des Bauteils 16 erfasst und bestimmt werden. Im Schritt S160 wird überprüft, ob das Bauteil 16, 16A, 16B den vorgegebenen Anforderungen entspricht. Wird im Schritt S160 festgestellt, dass das Bauteil 16, 16A, 16B den vorgegebenen Anforderungen nicht entspricht, dann wird das Bauteil 16, 16A, 16B als schlechtes Bauteil BTI_{B} bewertet und einem Nachbearbeitungsprozess bzw. Ausschussprozess übergeben, welcher im Schritt S600 durchgeführt wird. Wird das Bauteil 16, 16A, 16B im Schritt S160 als gutes Bauteil BTI_{G} bewertet, dann wird der mindestens eine bestimmte geometrische Parametern des jeweiligen Bauteils 16, 16A, 16B für das weitere Verfahren weitergegeben.

Die im Schritt S160 als gut bewerteten Bauteile BTIG werden im Schritt S170 auf der bedruckten Leiterplatte 18 platziert. Im Schritt S180 wird die Leiterplatte 18 mit den platzierten Bauteilen 16, 16A, 16B einem Lötofen zugeführt, in welchem die Lotpaste aufgeschmolzen wird, damit durch das entstehende Lot 15 eine feste elektrisch leitende Verbindung zwischen den Kontaktelementen 16.1 der Bauteile 16, 16A, 16B und den Lötflächen 14 der Leiterplatte 18 entsteht. Parallel zu den Schritten S170 und S180 wird im Schritt S200 in Abhängigkeit des mindestens einen bestimmten geometrischen Parameters des jeweiligen Bauteils 16, 16A, 16B und/oder des bestimmten mindestens einen geometrischen Parameters der mit Lot 15 benetzbaren Lötfläche 14 und/oder der bestimmten auf die Lötfläche 14 aufgebrachten Lotpastenmenge die Position und/oder die Abmessungen des mindestens einen korrespondierenden Inspektionsbereichs 12.1, 12.2 ermittelt und zur Lötstelleninspektion des Bauteils16, 16A, 16B für das weitere Verfahren vorgegeben.

Zudem wird im dargestellten Ausführungsbeispiel im Schritt S200 der Schwellwert für das mindestens eine Qualitätsmerkmal zur automatischen Lötstelleninspektion in Abhängigkeit des mindestens einen bestimmten geometrischen Parameters des Bauteils 16, 16A, 16B und/oder des bestimmten mindestens einen geometrischen Parameters der mit Lot 15 benetzbaren Lötfläche 14 und/oder der bestimmten Lotpastenmenge ermittelt und zur Überprüfung der korrespondierenden Lötstelle vorgegeben. Im Schritt S300 wird die automatische Lötstelleninspektion durchgeführt, durch welche in einem vorgegebenen Inspektionsbereich 12.1, 12.2 der Lötfläche 14 das mindestens eine Qualitätsmerkmal der zu überprüfenden Lötstelle 11 erfasst wird. Für die Position und/oder Abmessungen des Inspektionsbereichs 12.1, 12.2 werden die im Schritt S200 bestimmten Vorgaben verwendet. Im Schritt S310 wird der Wert des mindestens einen Qualitätsmerkmals mit dem vorgegebenen Schwellwert verglichen. Die zu überprüfende Lötstelle 11 wird im dargestellten Ausführungsbeispiel im Schritt S310 als gute Lötstelle ASJIR_{G} bewertet, wenn das mindestens eine Qualitätsmerkmal gleich dem vorgegebenen Schwellwert ist oder über dem vorgegebenen Schwellwert liegt. Die zu überprüfende Lötstelle 11 wird als schlechte Lötstelle ASJIR_{B} bewertet, wenn das mindestens eine Qualitätsmerkmal unter dem vorgegebenen Schwellwert liegt. In Abhängigkeit des gewählten mindestens einen Qualitätsmerkmals kann die zu überprüfende Lötstelle alternativ beispielsweise als gute Lötstelle bewertet werden, wenn das mindestens eine Qualitätsmerkmal unter dem vorgegebenen Schwellwert liegt, oder als schlechte Lötstelle bewertet werden, wenn das mindestens eine Qualitätsmerkmal gleich dem vorgegebenen Schwellwert ist oder über dem vorgegebenen Schwellwert liegt.

Sind die Lötstellen im Schritt S310 als gute Lötstellen ASJI_{RG} bewertet, dann wird die korrespondierende Leiterplatte 18 direkt dem nachfolgenden Produktionsprozess 9A übergeben, welcher im Schritt S500 durchgeführt wird. Ist mindestens eine Lötstelle 14 der Leiterplatte 18 als schlechte Lötstelle ASJI_{RB} bewertet worden, dann wird die Leiterplatte im Schritt S400 an den Nachüberprüfungsplatz 7 übergeben. Wird die bei der automatischen Lötstelleninspektion als schlecht bewertete mindestens eine Lötstelle ASJI_{RB} im Schritt S410 vom Prüfer in der Nachprüfung als gute Lötstelle HSJI_{RG} bewertet, dann wird die Leiterplatte ebenfalls an den nachfolgenden Produktionsprozess 9A übergeben, welcher im Schritt S500 durchgeführt wird. Wird die bei der automatischen Lötstelleninspektion als schlecht bewertete mindestens eine Lötstelle ASJI_{RB} im Schritt S410 vom Prüfer in der Nachprüfung ebenfalls als schlechte Lötstelle HSJI_{RB} bewertet, dann wird die Leiterplatte an den Nachbearbeitungsprozess bzw. Ausschussprozess 9B übergeben, welcher im Schritt S600 durchgeführt wird.

## Patentansprüche

1. Anlage (1, 1A) zur Lötstellenüberprüfung mit einer Vorrichtung (5) zur automatischen Lötstelleninspektion, welche eingerichtet ist, in einem vorgegebenen Inspektionsbereich (12.1, 12.2) der Lötfläche (14) mindestens ein Qualitätsmerkmal einer zu überprüfenden Lötstelle (11) zu erfassen, wobei die Vorrichtung (5) zur automatischen Lötstelleninspektion eingerichtet ist, die zu überprüfende Lötstelle (11) in Abhängigkeit des erfassten Qualitätsmerkmals als gute Lötstelle (ASJI_{RG}) oder als schlechte Lötstelle (ASJI_{RB}) zu bewerten, wobei eine Vorrichtung (4) zur automatischen Bauteilüberprüfung eingerichtet ist, mindestens einen geometrischen Parameter eines zu lötenden Bauteils (16, 16A, 16B) zu bestimmen, wobei eine Auswerte- und Steuereinheit (10, 10A) eingerichtet ist, in Abhängigkeit des bestimmten mindestens einen geometrischen Parameters des zu lötenden Bauteils (16, 16A, 16B) Position und/oder Abmessungen des mindestens einen korrespondierenden Inspektionsbereichs (12.1, 12.2) zu ermitteln und zur Überprüfung der korrespondierenden Lötstelle (11) an die Vorrichtung (5) zur automatischen Lötstelleninspektion vorzugeben, **dadurch gekennzeichnet, dass** die Vorrichtung (4) zur automatischen Bauteilüberprüfung eingerichtet ist, vor der Platzierung (S170) des zu lötenden Bauteils (16, 16A, 16B) als den geometrischen Parameter des zu lötenden Bauteils mindestens einen aktuellen geometrischen Parameter des zu lötenden Bauteils (16, 16A, 16B), wie die reale Bauteillänge, zu erfassen.

2. Anlage nach Anspruch 1, **dadurch gekennzeichnet, dass** die Vorrichtung (5) zur automatischen Lötstelleninspektion eingerichtet, ist das in einem vorgegebenen Inspektionsbereich (12) der zu überprüfenden Lötstelle (11) erfasste mindestens eine Qualitätsmerkmal mit mindestens einem vorgegebenen Schwellwert zu vergleichen und in Abhängigkeit des Vergleichsergebnisses die zu überprüfende Lötstelle (11) als gute Lötstelle (ASJI_{RG}) oder als schlechte Lötstelle (ASJI_{RB}) zu bewerten.

3. Anlage nach Anspruch 1 oder 2, **dadurch gekennzeichnet, dass** eine Vorrichtung (2) zur automatischen Lötflächenüberprüfung eingerichtet ist, mindestens einen geometrischen Parameter der mit Lot (15) benetzbaren Lötfläche (14) der zu überprüfenden Lötstelle (11) zu bestimmen.

4. Anlage nach einem der Ansprüche 1 bis 3, **dadurch gekennzeichnet, dass** eine Vorrichtung (3) zur automatischen Lotpastenüberprüfung eingerichtet ist, eine auf die Lötfläche (14) der zu überprüfenden Lötstelle (11) aufgebrachte Lotpastenmenge zu bestimmen.

5. Anlage nach Anspruch 3 oder 4, **dadurch gekennzeichnet, dass** die Auswerte- und Steuereinheit (10A) eingerichtet ist, Informationen über den bestimmten mindestens einen geometrischen Parameter der mit Lot (15) benetzbaren Lötfläche (14) und/oder die bestimmte auf die Lötfläche (14) aufgebrachte Lotpastenmenge bei der Ermittlung der Position und/oder der Abmessungen des mindestens einen korrespondierenden Inspektionsbereichs (12.1, 12.2) zu verwenden.

6. Anlage nach einem der Ansprüche 3 bis 5, **dadurch gekennzeichnet, dass** die Auswerte- und Steuereinheit (10A) eingerichtet ist, in Abhängigkeit des mindestens einen geometrischen Parameters eines zu lötenden Bauteils (16, 16A, 16B) und/oder des ermittelten mindestens einen geometrischen Parameters der mit Lot (15) benetzbaren Lötfläche (14) und/oder der ermittelten auf die Lötfläche (14) aufgebrachten Lotpastenmenge den mindestens einen Schwellwert für das mindestens eine Qualitätsmerkmal zu ermitteln und zur Überprüfung der korrespondierenden Lötstelle (11) an die Vorrichtung (5) zur automatischen Lötstelleninspektion vorzugeben.

7. Anlage nach einem der Ansprüche 1 bis 6, **dadurch gekennzeichnet, dass** die Vorrichtung (4) zur automatischen Bauteilüberprüfung eingerichtet ist, als geometrischen Parameter des zu lötenden Bauteils (16, 16A, 16B) eine aktuelle Bauteillänge zu ermitteln.

8. Anlage nach einem der Ansprüche 7, **dadurch gekennzeichnet, dass** die Vorrichtung (4) zur automatischen Bauteilüberprüfung eingerichtet ist, den Abstand (A, A-, A+) zwischen zwei Inspektionsbereichen (12.1, 12.2) in Abhängigkeit der aktuellen Bauteillänge vorzugeben.

9. Anlage nach einem der Ansprüche 1 bis 8, **dadurch gekennzeichnet, dass** ein Nachüberprüfungsplatz (7) vorhanden ist, welcher zur nochmaligen Überprüfung der als schlechte Lötstelle (ASJI_{RB}) bewerteten Lötstellen (11) durch einen menschlichen Prüfer eingerichtet ist.

10. Verfahren zur Lötstellenüberprüfung mit einer automatischen Lötstelleninspektion, durch welche in einem vorgegebenen Inspektionsbereich (12.1, 12.2) der Lötfläche (14) mindestens ein Qualitätsmerkmal einer zu überprüfenden Lötstelle (11) erfasst wird, wobei die zu überprüfende Lötstelle (11) in Abhängigkeit des erfassten Qualitätsmerkmals als gute Lötstelle (ASJI_{RG}) oder als schlechte Lötstelle (ASJI_{RB}) bewertet wird, wobei eine automatische Bauteilüberprüfung mindestens einen geometrischen Parameter eines zu lötenden Bauteils (16, 16A, 16B) ermittelt, wobei Position und/oder Abmessungen des mindestens einen korrespondierenden Inspektionsbereichs (12.1, 12.2) für die Lötstelleninspektion in Abhängigkeit des bestimmten mindestens einen geometrischen Parameters vorgegeben werden, **dadurch gekennzeichnet, dass** eine Vorrichtung (4) zur automatischen Bauteilüberprüfung vor der Platzierung (S170) des zu lötenden Bauteils (16, 16A, 16B) als den geometrischen Parameter des zu lötenden Bauteils mindestens einen aktuellen geometrischen Parameter des zu lötenden Bauteils (16, 16A, 16B), wie die reale Bauteillänge, erfasst.

11. Verfahren nach Anspruch 10, **dadurch gekennzeichnet, dass** das in einem vorgegebenen Inspektionsbereich (12) der zu überprüfenden Lötstelle (11) erfasste mindestens eine Qualitätsmerkmal mit mindestens einem vorgegebenen Schwellwert verglichen wird, wobei in Abhängigkeit des Vergleichsergebnisses die zu überprüfende Lötstelle (11) als gute Lötstelle (ASJI_{RG}) oder als schlechte Lötstelle (ASJI_{RB}) bewertet wird.

12. Verfahren nach Anspruch 10 oder 11, **dadurch gekennzeichnet, dass** eine automatische Lötflächenüberprüfung mindestens einen geometrischen Parameter der mit Lot (15) benetzbaren Lötfläche (14) der zu überprüfenden Lötstelle (11) bestimmt.

13. Verfahren nach einem der Ansprüche 10 bis 12, **dadurch gekennzeichnet, dass** eine automatische Lotpastenüberprüfung eine auf die Lötfläche (14) der zu überprüfenden Lötstelle (11) aufgebrachte Lotpastenmenge bestimmt.

14. Verfahren nach Anspruch 12 oder 13, **dadurch gekennzeichnet, dass** die Informationen über den bestimmten mindestens einen geometrischen Parameter der mit Lot (15) benetzbaren Lötfläche (14) und/oder die bestimmte auf die Lötfläche (14) aufgebrachte Lotpastenmenge bei der Ermittlung der Position und/oder der Abmessungen des mindestens einen korrespondierenden Inspektionsbereichs (12.1, 12.2) verwendet werden.

15. Verfahren nach einem der Ansprüche 12 bis 14, **dadurch gekennzeichnet, dass** der mindestens eine Schwellwert für das mindestens eine Qualitätsmerkmal in Abhängigkeit des mindestens einen geometrischen Parameters eines zu lötenden Bauteils (16, 16A, 16B) und/oder des bestimmten mindestens einen geometrischen Parameters der mit Lot (15) benetzbaren Lötfläche (14) und/oder der bestimmten auf die Lötfläche (14) aufgebrachten Lotpastenmenge ermittelt und zur Überprüfung der korrespondierenden Lötstelle (11) vorgegeben wird.

16. Verfahren nach einem der Ansprüche 10 bis 15, **dadurch gekennzeichnet, dass** als geometrischer Parameter des zu lötenden Bauteils (16, 16A, 16B) eine aktuelle Bauteillänge ermittelt wird.

17. Verfahren nach einem der Ansprüche 16, **dadurch gekennzeichnet, dass** in Abhängigkeit der aktuellen Bauteillänge ein Abstand (A, A-, A+) zwischen zwei Inspektionsbereichen (12.1, 12.2) vorgeben wird.

18. Computerprogrammprodukt mit Programmcode zur Durchführung eines Verfahrens nach mindestens einem der Ansprüche 10 bis 17, wenn der Programmcode von einer Auswerte- und Steuereinheit (10, 10A) einer Anlage (1, 1A) zur Lötstellenüberprüfung mit einer Vorrichtung (5) zur automatischen Lötstelleninspektion und einer Vorrichtung (4) zur automatischen Bauteilüberprüfung ausgeführt wird.

19. Maschinenlesbares Speichermedium, auf dem das Computerprogrammprodukt nach Anspruch 18 gespeichert ist.

## Claims

1. System (1, 1A) for checking solder joints, with a device (5) for automatic solder joint inspection, which is designed to detect at least one quality feature of a solder joint (11) to be checked in a predetermined inspection region (12.1, 12.2) of the solder surface (14), wherein the device (5) for automatic solder joint inspection is designed to assess the solder joint (11) to be checked, according to the detected quality feature, as a good solder joint (ASJI_{RG}) or as a bad solder joint (ASJI_{RB}), wherein a device (4) for automatic component checking is designed to determine at least one geometrical parameter of a component (16, 16A, 16B) to be soldered, wherein an evaluation and control unit (10, 10A) is designed to ascertain the position and/or dimensions of the at least one corresponding inspection region (12.1, 12.2), according to the determined at least one geometrical parameter of the component (16, 16A, 16B) to be soldered, and to specify them to the device (5) for automatic solder joint inspection for checking the corresponding solder joint (11), **characterized in that** the device (4) for automatic component checking is designed to detect at least one current geometrical parameter of the component (16, 16A, 16B) to be soldered, such as the actual component length, before the placement (S170) of the component (16, 16A, 16B) to be soldered as the geometrical parameter of the component to be soldered.

2. System according to Claim 1, **characterized in that** the device (5) for automatic solder joint inspection is designed to compare the at least one quality feature detected in a predetermined inspection region (12) of the solder joint (11) to be checked with at least one specified threshold value and to assess the solder joint (11) to be checked, according to the result of the comparison, as a good solder joint (ASJI_{RG}) or as a bad solder joint (ASJI_{RB}).

3. System according to Claim 1 or 2, **characterized in that** a device (2) for automatic solder surface checking is designed to determine at least one geometrical parameter of the solder surface (14) of the solder joint (11) to be checked that can be wetted with solder (15).

4. System according to one of Claims 1 to 3, **characterized in that** a device (3) for automatic solder paste checking is designed to determine an amount of solder paste applied to the solder surface (14) of the solder joint (11) to be checked.

5. System according to Claim 3 or 4, **characterized in that** the evaluation and control unit (10A) is designed to use information about the determined at least one geometrical parameter of the solder surface (14) that can be wetted with solder (15) and/or the determined amount of solder paste applied to the solder surface (14) in the ascertainment of the position and/or the dimensions of the at least one corresponding inspection region (12.1, 12.2).

6. System according to one of Claims 3 to 5, **characterized in that** the evaluation and control unit (10A) is designed to ascertain the at least one threshold value for the at least one quality feature, according to the at least one geometrical parameter of a component (16, 16A, 16B) to be soldered and/or the ascertained at least one geometrical parameter of the solder surface (14) that can be wetted with solder (15) and/or the ascertained amount of solder paste applied to the solder surface (14), and to specify them to the device (5) for automatic solder joint inspection for checking the corresponding solder joint (11).

7. System according to one of Claims 1 to 6, **characterized in that** the device (4) for automatic component checking is designed to ascertain a current component length as the geometrical parameter of the component (16, 16A, 16B) to be soldered.

8. System according to one of Claims 7, **characterized in that** the device (4) for automatic component checking is designed to specify the distance (A, A-, A+) between two inspection regions (12.1, 12.2) according to the current component length.

9. System according to one of Claims 1 to 8, **characterized in that** there is a rechecking station (7), which is designed for checking once again by a human inspector the solder joints (11) assessed as a bad solder joint (ASJI_{RB}).

10. Method for checking solder joints, with an automatic solder joint inspection, by which at least one quality feature of a solder joint (11) to be checked is detected in a predetermined inspection region (12.1, 12.2) of the solder surface (14), wherein the solder joint (11) to be checked is assessed, according to the detected quality feature, as a good solder joint (ASJI_{RG}) or as a bad solder joint (ASJI_{RB}), wherein an automatic component check ascertains at least one geometrical parameter of a component (16, 16A, 16B) to be soldered, wherein the position and/or dimensions of the at least one corresponding inspection region (12.1, 12.2) are specified for the solder joint inspection, according to the determined at least one geometrical parameter, **characterized in that** a device (4) for automatic component checking detects at least one current geometrical parameter of the component (16, 16A, 16B) to be soldered, such as the actual component length, before the placement (S170) of the component (16, 16A, 16B) to be soldered as the geometrical parameter of the component to be soldered.

11. Method according to Claim 10, **characterized in that** the at least one quality feature detected in a predetermined inspection region (12) of the solder joint (11) to be checked is compared with at least one specified threshold value, wherein the solder joint (11) to be checked is assessed, according to the result of the comparison, as a good solder joint (ASJI_{RG}) or as a bad solder joint (ASJI_{RB}).

12. Method according to Claim 10 or 11, **characterized in that** an automatic solder surface check determines at least one geometrical parameter of the solder surface (14) of the solder joint (11) to be checked that can be wetted with the solder (15).

13. Method according to one of Claims 10 to 12, **characterized in that** an automatic solder paste check determines an amount of solder paste applied to the solder surface (14) of the solder joint (11) to be checked.

14. Method according to Claim 12 or 13, **characterized in that** the information about the determined at least one geometrical parameter of the solder surface (14) that can be wetted with solder (15) and/or the determined amount of solder paste applied to the solder surface (14) is used in the ascertainment of the position and/or the dimensions of the at least one corresponding inspection region (12.1, 12.2).

15. Method according to one of Claims 12 to 14, **characterized in that** the at least one threshold value for the at least one quality feature is ascertained, according to the at least one geometrical parameter of a component (16, 16A, 16B) to be soldered and/or the determined at least one geometrical parameter of the solder surface (14) that can be wetted with solder (15) and/or the determined amount of solder paste applied to the solder surface (14), and is specified for checking the corresponding solder joint (11).

16. Method according to one of Claims 10 to 15, **characterized in that** a current component length is ascertained as the geometrical parameter of the component (16, 16A, 16B) to be soldered.

17. Method according to one of Claims 16, **characterized in that** a distance (A, A-, A+) between two inspection regions (12.1, 12.2) is specified according to the current component length.

18. Computer program product with program code for carrying out a method according to at least one of Claims 10 to 17 when the program code is run by an evaluation and control unit (10, 10A) of a system (1, 1A) for checking solder joints, with a device (5) for automatic solder joint inspection and a device (4) for automatic component checking.

19. Machine-readable storage medium, on which the computer program product according to Claim 18 is stored.

## Revendications

1. Système (1, 1A) de vérification de points de brasage, comprenant un dispositif d'inspection automatique des points de brasage (5) qui est aménagé pour détecter dans une zone d'inspection prédéfinie (12.1, 12.2) de la surface de brasage (14) au moins une caractéristique de qualité d'un point de brasage à vérifier (11), dans lequel le dispositif d'inspection automatique des points de brasage (5) est aménagé pour évaluer le point de brasage à vérifier (11) en fonction de la caractéristique de qualité détectée comme étant un bon point de brasage (ASJI_{RG}) ou un mauvais point de brasage (ASJI_{RB}), dans lequel un dispositif de vérification de composant automatique (4) est aménagé pour déterminer au moins un paramètre géométrique d'un composant à braser (16, 16A, 16B), dans lequel une unité d'évaluation et de commande (10, 10A) est aménagée pour déterminer en fonction du au moins un paramètre géométrique déterminé du composant à braser (16, 16A, 16B) la position et/ou les dimensions de ladite au moins une zone d'inspection correspondante (12.1, 12.2) et pour les spécifier au dispositif d'inspection automatique des points de brasage (5) pour la vérification du point de brasage correspondant (11), **caractérisé en ce que** le dispositif de vérification de composant automatique (4) est aménagé pour détecter, avant la mise en place (S170) du composant à braser (16, 16A, 16B), comme le paramètre géométrique du composant à braser au moins un paramètre géométrique actuel du composant à braser (16, 16A, 16B), tel que la longueur de composant réelle.

2. Système selon la revendication 1, **caractérisé en ce que** le dispositif d'inspection automatique des points de brasage (5) est aménagé pour comparer ladite au moins une caractéristique de qualité détectée dans une zone d'inspection prédéfinie (12) du point de brasage à vérifier (11) à au moins une valeur seuil prédéfinie, et pour évaluer en fonction du résultat de comparaison le point de brasage à vérifier (11) comme étant un bon point de brasage (ASJI_{RG}) ou un mauvais point de brasage (ASJI_{RB}).

3. Système selon la revendication 1 ou 2, **caractérisé en ce qu'**un dispositif de vérification automatique de surface de brasage (2) est aménagé pour déterminer au moins un paramètre géométrique de la surface de brasage (14), sur laquelle peut être appliqué le métal d'apport (15), du point de brasage à vérifier (11).

4. Système selon l'une quelconque des revendications 1 à 3, **caractérisé en ce qu'**un dispositif de vérification automatique de pâte à braser (3) est aménagé pour déterminer une quantité de pâte à braser appliquée sur la surface de brasage (14) du point de brasage à vérifier (11).

5. Système selon la revendication 3 ou 4, **caractérisé en ce que** l'unité d'évaluation et de commande (10A) est aménagée pour utiliser des informations concernant ledit au moins un paramètre géométrique déterminé de la surface de brasage (14) sur laquelle peut être appliqué le métal d'apport (15), et/ou la quantité de pâte à braser déterminée appliquée sur la surface de brasage (14) lors de la détermination de la position et/ou des dimensions de ladite au moins une zone d'inspection correspondante (12.1, 12.2).

6. Système selon l'une quelconque des revendications 3 à 5, **caractérisé en ce que** l'unité d'évaluation et de commande (10A) est aménagée pour déterminer en fonction dudit au moins un paramètre géométrique d'un composant à braser (16, 16A, 16B) et/ou dudit au moins un paramètre géométrique déterminé de la surface de brasage (14) sur laquelle peut être appliqué le métal d'apport (15) et/ou de la quantité de pâte à braser déterminée, appliquée sur la surface de brasage (14), ladite au moins une valeur seuil pour ladite au moins une caractéristique de qualité, et pour la spécifier au dispositif d'inspection automatique des points de brasage (5) pour la vérification du point de brasage correspondant (11).

7. Système selon l'une quelconque des revendications 1 à 6, **caractérisé en ce que** le dispositif de vérification de composant automatique (4) est aménagé pour déterminer une longueur de composant actuelle comme le paramètre géométrique du composant à braser (16, 16A, 16B).

8. Système selon l'une quelconque des revendications 7, **caractérisé en ce que** le dispositif de vérification de composant automatique (4) est aménagé pour spécifier la distance (A, A-, A+) entre deux zones d'inspection (12.1, 12.2) en fonction de la longueur de composant actuelle.

9. Système selon l'une quelconque des revendications 1 à 8, **caractérisé en ce qu'**il existe un poste de revérification (7) qui est aménagé pour revérifier les points de brasage (11) évalués comme étant de mauvais points de brasage (ASJI_{RB}) par un contrôleur humain.

10. Procédé de vérification de points de brasage, comprenant une inspection automatique des points de brasage qui détecte dans une zone d'inspection prédéfinie (12.1, 12.2) de la surface de brasage (14) au moins une caractéristique de qualité d'un point de brasage à vérifier (11), dans lequel le point de brasage à vérifier (11) est évalué en fonction de la caractéristique de qualité détectée comme étant un bon point de brasage (ASJI_{RG}) ou un mauvais point de brasage (ASJI_{RB}), dans lequel une vérification de composant automatique détermine au moine un paramètre géométrique d'un composant à braser (16, 16A, 16B), dans lequel la position et/ou les dimensions de ladite au moins une zone d'inspection correspondante (12.1, 12.2) sont prédéfinies pour l'inspection de point de brasage en fonction dudit au moins un paramètre géométrique, **caractérisé en ce qu'**un dispositif de vérification de composant automatique (4) détecte, avant la mise en place (S170) du composant à braser (16, 16A, 16B), comme le paramètre géométrique du composant à braser au moins un paramètre géométrique actuel du composant à braser (16, 16A, 16B), tel que la longueur de composant réelle.

11. Procédé selon la revendication 10, **caractérisé en ce que** ladite au moins une caractéristique de qualité détectée dans une zone d'inspection prédéfinie (12) du point de brasage à vérifier (11) est comparée à au moins une valeur seuil prédéfinie, dans lequel, en fonction du résultat de comparaison, le point de brasage à vérifier (11) est évalué comme étant un bon point de brasage (ASJI_{RG}) ou un mauvais point de brasage (ASJI_{RB}).

12. Procédé selon la revendication 10 ou 11, **caractérisé en ce qu'**une vérification automatique de la surface de brasage détermine au moins un paramètre géométrique de la surface de brasage (14), sur laquelle peut être appliqué le métal d'apport (15), du point de brasage à vérifier (11).

13. Procédé selon l'une quelconque des revendications 10 à 12, **caractérisé en ce qu'**une vérification automatique de la pâte à braser détermine une quantité de pâte à braser appliquée sur la surface de brasage (14) du point de brasage à vérifier (11).

14. Procédé selon la revendication 12 ou 13, **caractérisé en ce que** les informations concernant ledit au moins un paramètre géométrique déterminé de la surface de brasage (14) sur laquelle peut être appliqué le métal d'apport (15) et/ou la quantité de pâte à braser déterminée, appliquée sur la surface de brasage (14), sont utilisées lors de la détermination de la position et/ou des dimensions de ladite au moins une zone d'inspection correspondante (12.1, 12.2).

15. Procédé selon l'une quelconque des revendications 12 à 14, **caractérisé en ce que** ladite au moins une valeur seuil pour ladite au moins une caractéristique de qualité est déterminée en fonction dudit au moins un paramètre géométriques d'un composant à braser (16, 16A, 16B) et/ou dudit au moins un paramètre géométrique déterminé de la surface de brasage (14) sur laquelle peut être appliqué le métal d'apport (15) et/ou de la quantité de pâte à braser déterminée, appliquée sur la surface de brasage (14), et est prédéfinie pour la vérification du point de brasage correspondant (11).

16. Procédé selon l'une quelconque des revendications 10 à 15, **caractérisé en ce qu'**une longueur de composant actuelle est déterminée comme le paramètre géométrique du composant à braser (16, 16A, 16B).

17. Procédé selon l'une quelconque des revendications 16, **caractérisé en ce qu'**une distance (A, A-, A+) entre deux zones d'inspection (12.1, 12.2) est prédéfinie en fonction de la longueur de composant actuelle.

18. Produit de programme informatique, comprenant du code programme pour effectuer un procédé selon au moins l'une des revendications 10 à 17 lorsque le code programme est exécuté par une unité d'évaluation et de commande (10, 10A) d'un système (1, 1A) de vérification de points de brasage comprenant un dispositif d'inspection automatique des points de brasage (5) et un dispositif de vérification de composant automatique (4).

19. Support de stockage lisible par machine, sur lequel est stocké le produit de programme informatique selon la revendication 18.
